# EUROPEAN PATENT APPLICATION

(11) **EP 4 236 129 A1**
(43) Date of publication of application: **30.08.2023**
(21) Application number: 21884608.7
(22) Date of filing: 23.08.2021
(51) Int. Cl.: H04L 1/00

(54) **COMMUNICATION DATA PROCESSING METHOD AND APPARATUS, DEVICE, AND STORAGE MEDIUM**

(30) Priority: 26.10.2020 CN 202011156922
(71) Applicant: Sanechips Technology Co., Ltd., Shenzhen, Guangdong 518055 (CN)
(72) Inventor: ZHANG, Bin, Shenzhen, Guangdong 518057 (CN)
(74) Representative: Ipsilon
(86) International application number: PCT/CN2021/114111
(87) International publication number: WO 2022/088876

(57) **Abstract**

Embodiments of the present disclosure disclose a processing method and apparatus for communication data, a device, and a storage medium. The method includes: determining a bit pattern according to coding parameters; mapping the bit pattern according to communication data to be coded and a check bit to obtain an initial bit sequence; respectively performing operations on each of a plurality of subsequences of the initial bit sequence with a preset matrix to obtain a target bit sequence; and generating bit indexes based on a transmission rate, and selecting bit data from the target bit sequence according to the bit indexes for transmission.

## Description

### CROSS-REFERENCE TO RELATED APPLICATIONS

The present disclosure is filed based on and claims the priority to Chinese Patent Application No. 202011156922.3 filed on October 26, 2020, the entire contents of which are incorporated herein by reference.

### TECHNICAL FIELD

The present disclosure relates to the technical field of communications, and in particular, to a processing method and apparatus for communication data, a device, and a storage medium.

### BACKGROUND

Row weights need to be compared in polar coding, and a row weight is the number of 1s in each row of a G matrix. A conventional method is counting the number of 1s in the G matrix and stored the number in advance. When comparison of the row weights in the polar coding is performed, the row weights stored in advance are read and compared. Such method needs to store the information about the row weights in advance. A conventional rate matching method is performing subblock interleaving, bit selection, and bit interleaving in sequence, and Random Access Memories (RAMs) need to be used to store data obtained after the bit selection between the bit selection and the subblock interleaving. Such rate matching method uses a lot of RAMs, and is not flexible in parallel implementation.

### SUMMARY

Embodiments of the present disclosure provide a processing method for communication data, including: determining a bit pattern according to coding parameters; mapping the bit pattern according to communication data to be coded and a check bit to obtain an initial bit sequence; respectively performing operations on each of a plurality of subsequences of the initial bit sequence with a preset matrix to obtain a target bit sequence; and generating bit indexes based on a transmission rate, and selecting bit data from the target bit sequence according to the bit indexes for transmission..

The embodiments of the present disclosure provide a processing apparatus for communication data, including: a bit pattern determination module configured to determine a bit pattern according to coding parameters; an initial bit sequence obtaining module configured to map the bit pattern according to communication data to be coded and a check bit to obtain an initial bit sequence; a target bit sequence obtaining module configured to respectively perform operations on each of a plurality of subsequences of the initial bit sequence with a preset matrix to obtain a target bit sequence; and a data selection module configured to generate bit indexes based on a transmission rate, and select bit data from the target bit sequence according to the bit indexes for transmission.

The embodiments of the present disclosure provide a computer device, including a memory, a processor, and a computer program which is stored on the memory and is executable on the processor, and the processor performs, when executing the program, the processing method for communication data provided by the embodiments of the present disclosure.

The embodiments of the present disclosure provide a computer-readable storage medium having thereon stored a computer program which, when executed by a processor, implements the processing method for communication data provided by the embodiments of the present disclosure.

### BRIEF DESCRIPTION OF DRAWINGS

FIG. 1 is a diagram illustrating a front-back relationship between polar encoding and rate matching in Uplink Control Information (UCI) processing according to the embodiments of the present disclosure;
FIG. 2 is a flowchart illustrating a processing method for communication data according to the embodiments of the present disclosure;
FIG. 3 is a diagram of elements in a G matrix according to the embodiments of the present disclosure;
FIG. 4 is a diagram illustrating a matrix addition operation according to the embodiments of the present disclosure;
FIG. 5 is a schematic structural diagram of a processing apparatus for communication data according to the embodiments of the present disclosure; and
FIG. 6 is a schematic structural diagram of a computer device according to the embodiments of the present disclosure.

### DETAIL DESCRIPTION OF EMBODIMENTS

In order to make the objectives, technical solutions and advantages of the present disclosure clearer, the embodiments of the present disclosure are described in detail below in conjunction with the drawings. It should be noted that the embodiments described herein and the features therein can be arbitrarily combined with one another if no conflict is incurred.

It should be understood that the specific embodiments described herein are merely intended to explain the present disclosure, rather than limiting the present disclosure.

In the following description, the terms such as "module", "component" and "unit" used to indicate elements are employed merely for facilitating the description of the present disclosure, and those terms have no particular meaning in themselves. Thus, "module", "component" and "unit" can be used together.

The polar coding is a coding manner for the UCI introduced into 5G protocols. The row weights need to be compared in the polar coding, and the row weight is the number of 1s in each row of the G matrix. The conventional method is counting the number of 1s in the G matrix and stored the number in advance. When the comparison of the row weights in the polar coding is performed, the row weights stored in advance are read and compared. Such method needs to store the information about the row weights in advance. The conventional rate matching method is performing the subblock interleaving, the bit selection, and the bit interleaving in sequence, and the RAMs need to be used to store the data obtained after the bit selection between the bit selection and the subblock interleaving. Such rate matching method uses a lot of RAMs, and is not flexible in parallel implementation.

For realizing polar coding and rate matching of communication data, the embodiments of the present disclosure provide a processing method and apparatus for communication data, a device, and a storage medium, which can increase a processing rate of the communication data.

The embodiments of the present disclosure seeks to protect processes of polar coding and rate matching in UCI processing in 3GPP 5G NR physical layer protocols.

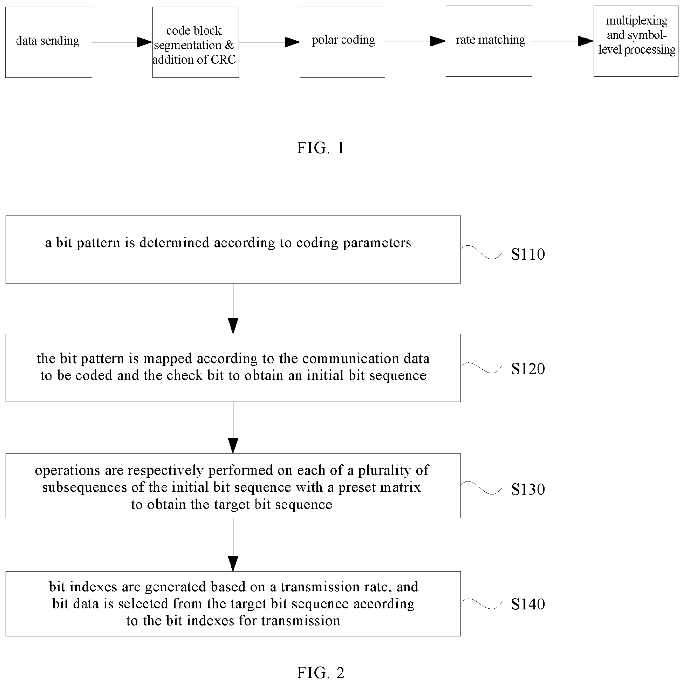

FIG. 1 shows a front-back relationship between the polar encoding and the rate matching in the UCI processing.

In an embodiment, FIG. 2 is a flowchart illustrating a processing method for communication data according to the embodiments of the present disclosure. The method may be applicable to processing of communication data, and the communication data may be physical UCI. The method may be performed by a data interrupt processing device. As shown in FIG. 2, the method includes S110 to S140.

In S110, a bit pattern is determined according to coding parameters.

The coding parameters may include a first code length and address weights. The first code length may be interpreted as a code length of a sequence obtained after polar coding, i.e., a code length of a target bit sequence; and the address weights may be acquired from a weight table. The bit pattern may be interpreted as a bit sequence, and whether communication data to be coded is added to a bit or a check bit is added to the bit may be determined according to each bit value and each bit index in the bit sequence.

In an embodiment, a way of determining the bit pattern according to the coding parameters may be: determining an address segment according to the first code length, and acquiring an address weight of each address in the address segment; for each address, performing a subblock de-interleaving operation on the address weight to determine whether the address is a puncturing position or a shortening position; if the address is the puncturing position or the shortening position, setting a bit value of the address to be 0; if the address is not the puncturing position or the shortening position, setting the bit value of the address to be 1, and adding 1 to number of effective bits; when the check bit exists, determining whether the address is the check bit according to a row weight of the address and/or the number of effective bits; and if the address is the check bit, recording the address weight as a check index.

The first code length N may be determined according to coding requirements, and may be 32, 64, 128, 256, 512 or 1024. In this embodiment, the address segment and the address weight Q of each address in the address segment may be determined by looking up a table. Table 1 shows a corresponding relationship between the first code length and the address segment.

**Table 1**

| N | ROM Address |
|---|---|
| 1024 | 0-1023 |
| 512 | 1024-1535 |
| 256 | 1536-1791 |
| 128 | 1792-1919 |
| 64 | 1920-1983 |
| 32 | 1984-2015 |

In this embodiment, a plurality of address weights are extracted from a protocol table according to the first code length N, and the address weights are sequentially stored in descending order in an ROM address range shown in Table 1.

Optionally, a way of performing the subblock de-interleaving operation on the address weight to determine whether the address is the puncturing position or the shortening position may be: converting the address weight into a ten-bit binary code; performing bit truncation on the ten-bit binary code according to the first code length to obtain a first value; looking up a table according to the first value to obtain a second value; obtaining a third value by performing a calculation based on the second value and the first code length; adding the third value to values truncated off from the ten-bit binary code to obtain a fourth value; and determining whether the address is the puncturing position or the shortening position according to the fourth value.

Exemplarily, performing the bit truncation on the ten-bit binary code according to the first code length is implemented in a way illustrated by Table 2.

**Table 2**

| N/32 | 1 | 2 | 4 | 8 | 16 | 32 |
|---|---|---|---|---|---|---|
| p_i | j_n | j_n[9:1] | j_n[9:2] | j_n[9:3] | j_n[9:4] | j_n[9:5] |

As shown in Table 2, the ten-bit binary code is j_n, and the first value after the truncation is p_i. j_n[9:1] represents keeping values from a first bit to a ninth bit in j_n. For example, assuming that the first code length is 1024 and the ten-bit binary code j_n is 0100010101, p_i=j_i[9:5], that is, the values from the fifth bit to the ninth bit are kept, so a binary code of the first value is 01000, and the first value is 16.

Exemplarily, looking up the table according to the first value to obtain the second value may be implanted according to Table 3.

**Table 3**

| **p_i** | **i** |
|---|---|
| 0,1,2 | p_i |
| 3 | 4 |
| 4 | 3 |
| 5,6,7,8 | p_i |
| 9 | 10 |
| 10 | 12 |
| 11 | 14 |
| 12 | 16 |
| 13 | 18 |
| 14 | 20 |
| 15 | 22 |
| 16 | 9 |
| 17 | 11 |
| 18 | 13 |
| 19 | 15 |
| 20 | 17 |
| 21 | 19 |
| 22 | 21 |
| 23,24,25,26 | p_i |
| 27 | 28 |
| 28 | 27 |
| 29,30,31 | p_i |

As can be seen from Table 3, the first value p_i and the second value i have a corresponding relationship. Assuming that the first value is 16, the second value is 9.

Exemplarily, obtaining the third value by calculating according to the second value and the first code length may be implemented by the following formula: d=i^{∗}N/32, where d denotes the third value, i denotes the second value, and N denotes the first code length. Assuming that the second value is 9, the third value is 9 ^{∗} 32.

Exemplarily, adding the third value to the truncated values of the ten-bit binary code to obtain the fourth value may be implemented according to Table 4. As shown in Table 4, assuming that the first code length is 1024 and the ten-bit binary code j_n is 0100010101, the truncated values are j_i[4:0]=10101, which is 21 after being converted into a decimal system, and the fourth value is 9 * 32 + 21

**Table 4**

| N/32 | 1 | 2 | 4 | 8 | 16 | 32 |
|---|---|---|---|---|---|---|
| n | n' | n'+j_n[0] | n'+j_n[1:0] | n'+j_n[2:0] | n'+j_n[3:0] | n'+j_n[4:0] |

In this embodiment, after the fourth value is obtained, it may be determined whether the address is the puncturing position or the shortening position according to specifications of the protocols.

In an embodiment, the coding parameters further include a second code length, which is a code length of the communication data to be coded; a process of determining whether the address is the check bit according to the row weight of the address and/or the number of effective bits may be: in a case where a set check bit exists, when the number of effective bits is less than or equal to the second code length, determining whether the row weight of the address is a minimum of recorded row weights, and if the row weight of the address is the minimum of the recorded row weights, recording the address weight as a first check index; when the number of effective bits is equal to a sum of the second code length and 2, recording the address weight as a second check index; when the number of effective bits is equal to a sum of the second code length and 3, recording the address weight as a third check index; in a case where the set check bit does not exist, when the number of effective bits is equal to a sum of the second code length and 1, recording the address weight as the first check index; when the number of effective bits is equal to the sum of the second code length and 2, recording the address weight as the second check index; and when the number of effective bits is equal to the sum of the second code length and 3, recording the address weight as the third check index.

In this embodiment, the row weight of the address may be represented by the number of 1s included in an address index. In this way, it is not necessary to count the number of 1s in a G matrix to determine the row weight, so that the amount of computation can be significantly reduced.

The set check bit may be a pcwm bit. Exemplarily, in a case where the pcwm bit exists, when the number of effective bits is less than or equal to the second code length K, the row weight W corresponding to the address is compared with a recorded row weight W_min, and if W is less than W_min, the address weight Q is registered in pc_bit_index0; and when the number of effective bits is equal to K+2 and K+3, Q is stored in pc_bit_index1 and pc_bit_index2, respectively. In a case where the pcwm bit does not exist, when the number of effective bits is equal to K+1, K+2, and K+3, Q is stored in pc_bit_index0, pc_bit_index1, and pc_bit_index2, respectively. A position having a value of 1 in the finally obtained bit_pattern is a position to which the communication data to be coded may be mapped; and pc_bit_index0, pc_bit_index1, and pc_bit_index2 are positions to which the check bit may be mapped.

In S120, the bit pattern is mapped according to the communication data to be coded and the check bit to obtain an initial bit sequence.

Exemplarily, four bits are taken from the bit pattern each time according to an ascending order of the indexes, and according to whether values of the taken bits are 1 and whether the address weights of the bits are equal to the check indexes, bit data is selected from the communication data to be coded or the check bit and added to a corresponding address.

Exemplarily, a process of mapping the bit pattern according to the communication data to be coded and the check bit to obtain the initial bit sequence may be: sequentially extracting the bit in each address from the bit pattern, and if the address weight corresponding to the address is the check index, adding the selected check bit to the address; and if the bit value is 1 and the address weight corresponding to the address is not the check index, sequentially selecting the bit data from the communication data to be coded and adding the bit data to the address.

In S130, operations are respectively performed on each of a plurality of subsequences of the initial bit sequence with a preset matrix to obtain the target bit sequence.

The number of the bits included in each subsequence may be set in advance, such as 16 bits, 32 bits or 64 bits. Taking a case where each subsequence includes 32 bits as an example, Table 5 shows a relationship between the first code length N and the number of the subsequences.

**Table 5**

| N | 32 | 64 | 128 | 256 | 512 | 1024 |
|---|---|---|---|---|---|---|
| Number of Subsequences | 1 | 2 | 4 | 8 | 16 | 32 |

When matrix multiplication and matrix addition are performed, the multiplication and the addition are performed by taking the subsequence as a unit.

The preset matrix may be a G matrix. Exemplarily, a way of respectively performing operations on each of the plurality of subsequences of the initial bit sequence with the preset matrix may be: dividing the initial bit sequence into the plurality of subsequences, and respectively multiplying each of the plurality of subsequences by the preset matrix; and performing, in a set manner, a multi-stage addition operation on subsequences obtained after the multiplications.

A number of each subsequence is established, and Table 6 shows a corresponding relationship between the numbers and the initial bit sequence.

**Table 6**

| No. | U0 | U1 | U2 | ... | U31 |
|---|---|---|---|---|---|
| Initial Bit Sequence | u[31:0] | U[63:32] | U[95:64] | ... | U[1023:992] |

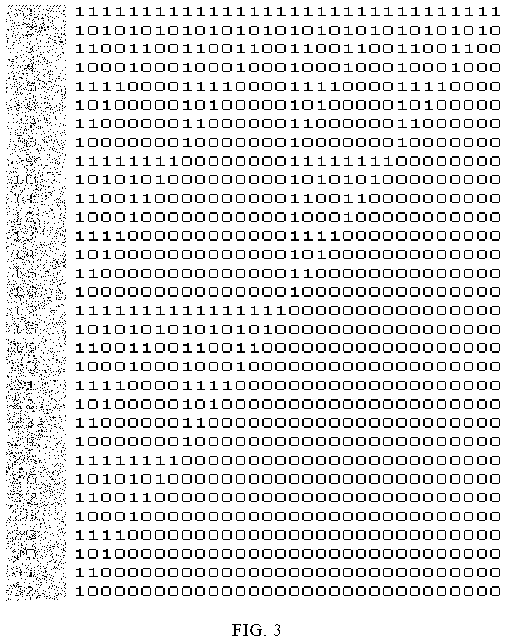

FIG. 3 is a diagram of elements in the G matrix according to the embodiments of the present disclosure. As shown in FIG. 3, the matrix is a 32^{∗}32 matrix. Each subsequence is multiplied by the G matrix.

Exemplarily, a process of performing, in the set manner, the multi-stage addition operation on the subsequences obtained after the multiplications may be: for each stage of the addition operation, dividing a plurality of subsequences obtained by a previous stage of the addition operation into two groups, and establishing one-to-one corresponding relationships between the subsequences in the two groups; performing the addition operation on the subsequences having the one-to-one corresponding relationships, and taking sequences obtained after the addition operation as new subsequences of one of the two groups; and keeping the subsequences of the other group unchanged.

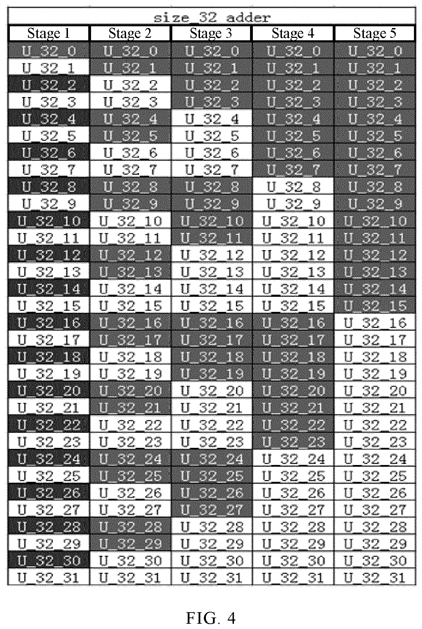

Illustratively, FIG. 4 is a diagram illustrating a matrix addition operation according to the embodiments of the present disclosure. As shown in FIG. 4, the addition operation is divided into 5 stages, the subsequences are divided into a black group and a white group in each stage, and the one-to-one corresponding relationships between the subsequences in the black group and the white group are sequentially established according to the numbers of the subsequences, for example, a one-to-one corresponding relationship is established between an M^{th} subsequence in the black group and an M^{th} subsequence in the white group. Then, the subsequences having the one-to-one corresponding relationships are subjected to the addition operation, the subsequences in the black group are replaced with the sequences obtained after the addition operation, and the subsequences in the white group are kept unchanged.

In S140, bit indexes are generated based on a transmission rate, and bit data is selected from the target bit sequence according to the bit indexes for transmission.

A way of generating the bit indexes based on the transmission rate may be: performing bit de-interleaving processing, bit de-selection processing, and subblock de-interleaving processing based on the transmission rate to obtain the bit indexes.

A process of the bit de-interleaving processing may be interpreted as calculating, for each interleaved bit index, a bit index before interleaving corresponding to the interleaved bit index according to a relationship between the bit index before interleaving and the interleaved bit index. In the embodiments of the present disclosure, the number of concurrently calculated bit indexes may be flexibly set according to a requirement of degree of parallelism.

A process of performing the bit de-selection processing based on the transmission rate may be: determining a rate matching mode according to the transmission rate and the first code length; and performing the bit de-selection processing according to the rate matching mode.

Exemplarily, input data of the bit de-election processing is an index bit_sel_index obtained after bit selection, output data of the bit de-election processing is an index pre_bit_sel_index before the bit selection, the first code length is recorded as N = 2 ^ m, and a data length after the rate matching is recorded as Er. A relationship between pre_bit_sel_index and bit_sel_index is shown in Table 7:

**Table 7**

| **Rate Matching Mode** | **m** | **pre_bit_sel_index** |
|---|---|---|
| puncturing mode | / | bit_sel_index+N-Er |
| shortening mode | / | bit_sel_index |
| repetition mode | 0 | bit_sel_index[4:0] |
| | 1 | bit_sel_index[5:0] |
| | 2 | bit_sel_index[6:0] |
| | 3 | bit_sel_index[7:0] |
| | 4 | bit_sel_index[8:0] |
| | 5 | bit_sel_index[9:0] |

According to the technical solution provided by the embodiments of the present disclosure, the bit pattern is first determined according to the coding parameters, then the communication data to be coded is mapped into input data for the polar coding and the check bit is added according to the bit pattern to obtain the initial bit sequence, the bit sequence is further divided into the plurality of subsequences, the plurality of subsequences are subjected to the multiplication operation and the addition operation with the matrix to obtain the target bit sequence, and finally the bit indexes are generated based on the transmission rate, and the bit data is selected from the target bit sequence according to the bit indexes for transmission. With the processing method for communication data provided by the embodiments of the present disclosure, by mapping the communication data to be coded into the input data for the polar coding and adding the check bit according to the bit pattern to obtain the initial bit sequence, efficiency of the polar coding can be increased; by dividing the bit sequence into the plurality of subsequences and subjecting the plurality of subsequences to the multiplication operation and the addition operation with the matrix to obtain the target bit sequence, instead of subjecting the whole bit sequence to the multiplication operation and the addition operation with the matrix, rates of the operations can be increased; and the rate matching is realized by selecting the bit data from the target bit sequence according to the bit indexes for transmission, rather than directly performing the rate matching on the target bit sequence, so that efficiency of the rate matching can be increased.

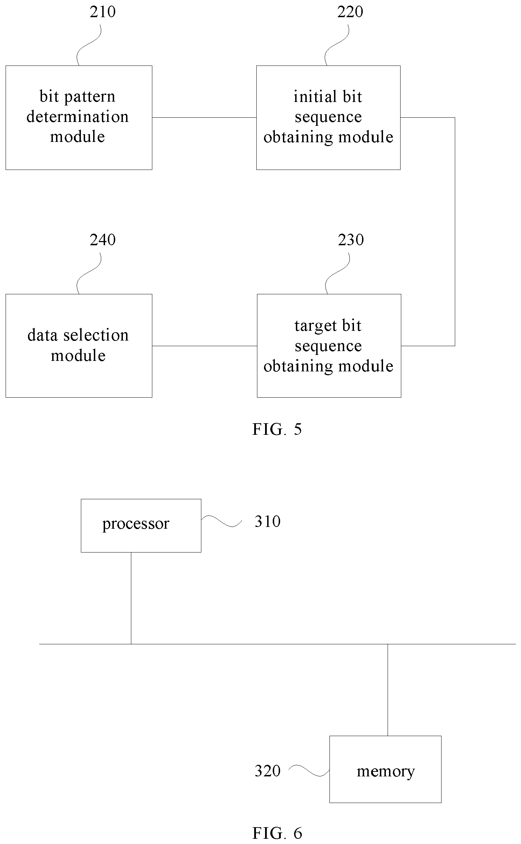

In an embodiment, FIG. 5 is a schematic structural diagram of a processing apparatus for communication data according to the embodiments of the present disclosure. As shown in FIG. 5, the apparatus includes: a bit pattern determination module 210, an initial bit sequence obtaining module 220, a target bit sequence obtaining module 230, and a data selection module 240.

The bit pattern determination module 210 is configured to determine a bit pattern according to coding parameters.

The initial bit sequence obtaining module 220 is configured to map the bit pattern according to communication data to be coded and a check bit to obtain an initial bit sequence.

The target bit sequence obtaining module 230 is configured to respectively perform operations on each of a plurality of subsequences of the initial bit sequence with a preset matrix to obtain a target bit sequence.

The data selection module 240 is configured to generate bit indexes based on a transmission rate, and select bit data from the target bit sequence according to the bit indexes for transmission.

In an embodiment, the coding parameters include a first code length and address weights; and the first code length is a code length of the target bit sequence. The bit pattern determination module 210 is further configured to: determine an address segment according to the first code length, and acquire an address weight of each address in the address segment; for each address, perform a subblock de-interleaving operation on the address weight to determine whether the address is a puncturing position or a shortening position; if the address is the puncturing position or the shortening position, set a bit value of the address to be 0; if the address is not the puncturing position or the shortening position, set the bit value of the address to be 1, and add 1 to an number of effective bits; when the check bit exists, determine whether the address is the check bit according to a row weight of the address and/or the number of effective bits; and if the address is the check bit, record the address weight as a check index.

In an embodiment, the bit pattern determination module 210 is further configured to: convert the address weight into a ten-bit binary code; perform bit truncation on the ten-bit binary code according to the first code length to obtain a first value; look up a table according to the first value to obtain a second value; obtain a third value by calculating according to the second value and the first code length; add the third value to truncated values of the ten-bit binary code to obtain a fourth value; and determine whether the address is the puncturing position or the shortening position according to the fourth value.

In an embodiment, the coding parameters further include a second code length, which is a code length of the communication data to be coded. The bit pattern determination module 210 is further configured to: in a case where a set check bit exists, when the number of effective bits is less than or equal to the second code length, determine whether the row weight of the address is a minimum of recorded row weights, and if the row weight of the address is the minimum of the recorded row weights, record the address weight as a first check index; when the number of effective bits is equal to a sum of the second code length and 2, record the address weight as a second check index; when the number of effective bits is equal to a sum of the second code length and 3, record the address weight as a third check index; in a case where the set check bit does not exist, when the number of effective bits is equal to a sum of the second code length and 1, record the address weight as the first check index; when the number of effective bits is equal to the sum of the second code length and 2, record the address weight as the second check index; and when the number of effective bits is equal to the sum of the second code length and 3, record the address weight as the third check index.

In an embodiment, the initial bit sequence obtaining module 220 is further configured to: sequentially extract a bit in each address from the bit pattern, and if an address weight corresponding to the address is the check index, add a selected check bit to the address; and if the bit value is 1 and the address weight corresponding to the address is not the check index, sequentially select the bit data from the communication data to be coded and add the bit data to the address.

In an embodiment, the target bit sequence obtaining module 230 is further configured to: divide the initial bit sequence into the plurality of subsequences, and respectively multiply each of the plurality of subsequences by the preset matrix; and perform, in a set manner, a multi-stage addition operation on subsequences obtained after the multiplications.

In an embodiment, the target bit sequence obtaining module 230 is further configured to: for each stage of the addition operation, divide a plurality of subsequences obtained by a previous stage of the addition operation into two groups, and establish one-to-one corresponding relationships between the subsequences in the two groups; perform the addition operation on the subsequences having the one-to-one corresponding relationships, and take sequences obtained after the addition operation as new subsequences of one of the two groups; and keep the subsequences of the other group unchanged.

In an embodiment, the data selection module 240 is further configured to: perform bit de-interleaving processing, bit de-selection processing, and subblock de-interleaving processing based on the transmission rate to obtain the bit indexes.

In an embodiment, the data selection module 240 is further configured to: determine a rate matching mode according to the transmission rate and the first code length; and perform the bit de-selection processing according to the rate matching mode.

In an embodiment, FIG. 6 is a schematic structural diagram of a computer device according to the embodiments of the present disclosure. As shown in FIG. 6, a device provided by the present disclosure includes: a processor 310 and a memory 320. The number of the processors 310 in the device may be one or more, and FIG. 6 illustrates an example in which one processor 310 is provided in the device. The number of the memories 320 in the device may be one or more, FIG. 6 illustrates an example in which one memory 320 is provided in the device. The processor 310 and the memory 320 in the device may be connected to each other through a bus or by other means, and FIG. 6 illustrates an example in which the processor 310 and the memory 320 are connected through the bus. In the embodiments, the device is a computer device.

As a computer-readable storage medium, the memory 320 may be configured to store software programs, computer-executable programs, and modules, such as program instructions/modules corresponding to the device provided by any of the embodiments of the present disclosure (e.g., the encoding module and the first sending module in the data transmission device). The memory 320 may include a program storage region and a data storage region, the program storage region is capable of storing an operating system, and at least one application program needed by function; and the data storage region is capable of storing data created according to use of the device. Further, the memory 320 may include a high-speed random access memory, and may also include a non-volatile memory, such as at least one of magnetic disk, a flash memory, or other non-volatile solid-state memories. In some examples, the memory 320 may further include a memory remotely arranged relative to the processor 310, and the remote memory may be connected to the device via a network. Examples of the network include, but are not limited to, the Internet, an intranet, a local area network, a mobile communication network, and the combinations thereof.

The device described above may be configured to perform the processing method applied to the communication data provided by any of the above embodiments, and has corresponding functions and effects.

The program stored in the corresponding memory 320 may be program instructions/modules provided by the embodiments of the present disclosure for an interrupt processing method, and the processor 310 performs one or more functional applications and data processing of the computer device by running the software programs, instructions, and module stored in the memory 320, that is, performing the association query method applied to data provided by the above method embodiments. It should be understood that, when the device is a receiving end, the device can perform the interrupt processing method provided by any of the embodiments of the present disclosure, and has corresponding functions and effects.

The embodiments of the present disclosure further provide a storage medium containing computer-executable instructions, which are configured to perform a processing method for communication data when executed by a computer processor, and the method includes: determining a bit pattern according to coding parameters; mapping communication data to be coded into input data for polar coding and adding a check bit according to the bit pattern to obtain an initial bit sequence; dividing the initial bit sequence into a plurality of subsequences, subjecting the plurality of subsequences to a multiplication operation and an addition operation with a matrix to obtain a target bit sequence; and generating bit indexes based on a transmission rate, and selecting bit data from the target bit sequence according to the bit indexes for transmission.

It should be understood by those of ordinary skill in the art that the term "user equipment" indicates any wireless user equipment of a suitable type, such as a mobile phone, a portable data processing device, a portable web browser or a vehicle mobile station.

In general, the various embodiments of the present disclosure may be implemented by hardware or special circuits, software, logic or any combination thereof. For example, some aspects of the present disclosure may be implemented by hardware and other aspects may be implemented by firmware or software executable by a controller, a microprocessor or other computing devices, but the present disclosure is not limited thereto.

The embodiments of the present disclosure may be implemented by a data processor of a mobile device executing computer program instructions. For example, the embodiments of the present disclosure are implemented in a processor entity, or by hardware, or by a combination of software and hardware. The computer program instructions may be assembly instructions, Instruction Set Architecture (ISA) instructions, machine instructions, machine-related instructions, microcode, firmware instructions, state setting data, or source code or object code written in one programming language or in any combination of a plurality of programming languages.

A block diagram illustrating any logic flow in the drawings of the present disclosure may show operations of a program, or interconnected logic circuits, modules, and functions, or a combination of the operations of the program and the logic circuits, modules, and functions. The computer program can be stored on the memory. The memory may be in any type suitable to local technical environment and may be implemented using any suitable data storage technology. For example, the memory is, but not limited to, a Read-Only Memory (ROM), an RAM, and an optical storage device and system (a Digital Video Disc (DVD) or a Compact Disc (CD)). A computer-readable medium may include a non-transitory storage medium. The data processor may be in any type suitable to the local technical environment. For example, the data processor is, but not limited to, a general-purpose computer, a special purpose computer, a microprocessor, a Digital Signal Processor (DSP), an Application Specific Integrated Circuit (ASIC), a Field-Programmable Gate Array (FGPA), and a processor based on multi-core architecture.

The above description is merely of the exemplary embodiments of the present disclosure, and is not intended to limit the scope of the present disclosure.

The embodiments of the present disclosure may be implemented by the data processor of the mobile device executing the computer program instructions. For example, the embodiments of the present disclosure are implemented in the processor entity, or by the hardware, or by the combination of software and hardware. The computer program instructions may be the assembly instructions, the ISA instructions, the machine instructions, the machine-related instructions, the microcode, the firmware instructions, the state setting data, or the source code or the object code written in one programming language or in any combination of a plurality of programming languages.

The exemplary embodiments of the present disclosure are illustrated in detail above by exemplary and non-limiting examples. For those of ordinary skill in the art, various modifications and adjustments to the above embodiments can be obviously derived from the accompanying drawings and the appended claims, but those modifications and adjustments are not beyond the scope of the present disclosure. Therefore, the proper scope of the present disclosure is defined by the appended claims.

## Claims

1. A processing method for communication data, comprising:
determining a bit pattern according to coding parameters;
mapping the bit pattern according to communication data to be coded and a check bit to obtain an initial bit sequence;
respectively performing operations on each of a plurality of subsequences of the initial bit sequence with a preset matrix to obtain a target bit sequence; and
generating bit indexes based on a transmission rate, and selecting bit data from the target bit sequence according to the bit indexes for transmission.

2. The method of claim 1, wherein the coding parameters comprise a first code length and address weights; the first code length being a code length of the target bit sequence; and determining the bit pattern according to the coding parameters comprises:
determining an address segment according to the first code length, and acquiring an address weight of each address in the address segment;
for each address, performing a subblock de-interleaving operation on the address weight to determine whether the address is a puncturing position or a shortening position;
in response to the address being the puncturing position or the shortening position, setting a bit value of the address to be 0; in response to the address being not the puncturing position or the shortening position, setting the bit value of the address to be 1, and adding 1 to number of effective bits;
in a case where the check bit exists, determining whether the address is the check bit according to a row weight of the address and/or the number of effective bits; and
in response to the address being the check bit, recording the address weight as a check index.

3. The method of claim 2, wherein performing the subblock de-interleaving operation on the address weight to determine whether the address is the puncturing position or the shortening position comprises:
converting the address weight into a ten-bit binary code;
performing bit truncation on the ten-bit binary code according to the first code length to obtain a first value;
looking up a table according to the first value to obtain a second value;
obtaining a third value by performing a calculation based on the second value and the first code length;
adding the third value to values truncated off from the ten-bit binary code to obtain a fourth value; and
determining whether the address is the puncturing position or the shortening position according to the fourth value.

4. The method of claim 2, wherein the coding parameters further comprise a second code length, the second code length being a code length of the communication data to be coded; and determining whether the address is the check bit according to the row weight of the address and/or the number of effective bits comprises:
in a case where a set check bit exists, when the number of effective bits is less than or equal to the second code length, determining whether the row weight of the address is a minimum of recorded row weights, and in response to the row weight of the address being the minimum of the recorded row weights, recording the address weight as a first check index;
when the number of effective bits is equal to a sum of the second code length and 2, recording the address weight as a second check index; when the number of effective bits is equal to a sum of the second code length and 3, recording the address weight as a third check index; and
in a case where the set check bit does not exist, when the number of effective bits is equal to a sum of the second code length and 1, recording the address weight as the first check index; when the number of effective bits is equal to the sum of the second code length and 2, recording the address weight as the second check index; and when the number of effective bits is equal to the sum of the second code length and 3, recording the address weight as the third check index.

5. The method of claim 2, wherein mapping the bit pattern according to the communication data to be coded and the check bit comprises:
sequentially extracting a bit in each address from the bit pattern, and in response to the address weight corresponding to the address being the check index, adding a selected check bit to the address; and
in response to the bit value being 1 and the address weight corresponding to the address being not the check index, sequentially selecting the bit data from the communication data to be coded and adding the bit data to the address.

6. The method of any one of claims 1 to 5, wherein respectively performing operations on each of the plurality of subsequences of the initial bit sequence with the preset matrix comprises:
dividing the initial bit sequence into the plurality of subsequences;
respectively multiplying each of the plurality of subsequences by the preset matrix; and
performing, in a set manner, a multi-stage addition operation on subsequences obtained after the multiplications.

7. The method of claim 6, wherein performing, in the set manner, the multi-stage addition operation on the subsequences obtained after the multiplications comprises:
for each stage of the addition operation, dividing a plurality of subsequences obtained by a previous stage of the addition operation into two groups, and establishing one-to-one corresponding relationships between the subsequences in the two groups; and
performing the addition operation on the subsequences having the one-to-one corresponding relationships, and taking sequences obtained after the addition operation as new subsequences of one of the two groups; and keeping the subsequences of the other group unchanged.

8. The method of any one of claims 1 to 7, wherein generating the bit indexes based on the transmission rate comprises:
performing bit de-interleaving processing, bit de-selection processing, and subblock de-interleaving processing based on the transmission rate to obtain the bit indexes.

9. The method of claim 8, wherein performing the bit de-selection processing based on the transmission rate comprises:
determining a rate matching mode according to the transmission rate and the first code length; and
performing the bit de-selection processing according to the rate matching mode.

10. A processing apparatus for communication data, comprising:
a bit pattern determination module configured to determine a bit pattern according to coding parameters;
an initial bit sequence obtaining module configured to map the bit pattern according to communication data to be coded and a check bit to obtain an initial bit sequence;
a target bit sequence obtaining module configured to respectively perform operations on each of a plurality of subsequences of the initial bit sequence with a preset matrix to obtain a target bit sequence; and
a data selection module configured to generate bit indexes based on a transmission rate, and select bit data from the target bit sequence according to the bit indexes for transmission.

11. A computer device, comprising a memory, a processor, and a computer program which is stored on the memory and is executable on the processor, wherein the processor performs, when executing the program, the processing method for communication data of any one of claims 1 to 9.

12. A computer-readable storage medium having thereon stored a computer program which, when executed by a processor, implements the processing method for communication data of any one of claims 1 to 9.
